# FASCICULE DE BREVET EUROPEEN

(11) **EP 1 448 805 B1**
(45) Date de publication et mention de la délivrance du brevet: **16.11.2005**
(21) Numéro de dépôt: 02801075.9
(22) Date de dépôt: 28.11.2002
(51) Int. Cl.: C23C 14/22

(54) **PROCEDE PERFECTIONNE DE REVETEMENT D UN SUPPORT PAR UN MATER IAU**
VERBESSERTES VERFAHREN ZUM BESCHICHTEN EINES TRÄGERS MIT EINEM MATERIAL
IMPROVED METHOD FOR COATING A SUPPORT WITH A MATERIAL

(30) Priorité: 28.11.2001 FR 0115366
(43) Date de publication de la demande: 25.08.2004
(73) Titulaire: EPPRA, 91140 Villebon sur Yvette (FR)
(72) Inventeur: CHOI, Peter, F-91400 Orsay (FR)
(74) Mandataire: Le Forestier, Eric
(86) Numéro de dépôt international: PCT/FR2002/004087
(87) Numéro de publication internationale: WO 2003/046248

(56) Documents cités:
- WO-A-96/22841
- WO-A-99/65038
- US-A- 4 652 357
- US-A- 4 714 641
- US-A- 4 743 308
- US-A- 4 759 948
- US-A- 5 532 495
- US-A- 6 086 726

## Description

La présente invention concerne de manière générale les procédés permettant de déposer, sur un support formé d'un premier matériau, une couche de revêtement comprenant un deuxième matériau ou des matériaux multiples dont les propriétés sont différentes de celles du matériau du support.

Plus précisément, l'invention concerne un procédé de revêtement d'un support, comprenant au moins une phase de dépôt de matériau cohérent.

Par « matériau cohérent » on entend un matériau qui présente une structure (cristallographique par exemple) cohérente : cette définition exclut ainsi des matériaux se présentant sous forme de liquides ou de poudres.

Plus précisément encore, l'invention concerne un procédé permettant d'obtenir un revêtement de très haute qualité (en particulier en termes d'homogénéité, de régularité de l'état de surface et de cohésion avec le support), ledit procédé présentant par rapport aux procédés connus des avantages importants de rapidité et de simplicité de mise en oeuvre, et de coût.

Le revêtement d'objets par une couche de matériau présentant des caractéristiques spécifiques (état de surface, dureté mécanique, résistance à l'oxydation, compacité, adhérence, étanchéité...) est extrêmement répandu dans de nombreux domaines (outillage, médical, industrie...), et on connaît de nombreuses techniques pour déposer sur un objet une couche de matériau de revêtement.

Un premier type de technique classique, désigné par l'acronyme CVD (déposition chimique en phase vapeur) consiste à provoquer une réaction chimique de manière à faire passer en phase gazeuse un matériau, puis à condenser la phase gazeuse obtenue sur un support de manière à ce que le matériau se dépose sur le support.

Pour mettre en oeuvre ce type de technique, il est nécessaire de contrôler les conditions de température et de pression afin de permettre les changements d'état du matériau à déposer sur le support. On connaît ainsi des techniques de dépôt sous vide qui permettent d'améliorer le dépôt et d'augmenter les quantités de matériau déposées.

Mais la qualité des revêtements obtenus par ces techniques connues est limitée, car les molécules du matériau de revêtement sont « déposées »au sens littéral du terme sur le support, l'adhérence du revêtement sur le support étant alors de qualité moyenne, ce qui peut se révéler inacceptables pour certaines applications.

De plus, ces techniques ne permettent pas d'obtenir des revêtements dont la surface soit extrêmement lisse, ce qui est souhaité pour de nombreuses applications (par exemple pour des considérations esthétiques, ou encore en vue d'utiliser les avantages liés à un coefficient de frottement très faible).

On précise que la qualité du revêtement obtenue dépend d'une part de l'état originaire de la surface du support, et d'autre part de la méthode de déposition en effet les différentes méthodes connues peuvent aboutir à des revêtements de qualités bien différentes.

Pour améliorer les performances de ce premier type de technique connu, il est également bien connu de créer un plasma de température faible (avec des ions d'énergie inférieure à 1 eV).

La migration du matériau de revêtement sur le support est contrôlée par la température du support (qui peut être augmentée par irradiation avec de la chaleur) ou par le bombardement des ions extraits du plasma de déposition et utilisés pour favoriser la croissance du revêtement (ion assisted deposition) en appliquant sur le support un potentiel électrique négatif, par exemple de 50 à 200 eV.

Pour améliorer le revêtement, on peut également augmenter la température du support de manière à obtenir une meilleure adhésion au contact, ou utiliser un faisceau d'ions supplémentaire de quelques dizaines de KeV pour accompagner le dépôt. Ces méthodes sont des méthodes additionnelles qui favorisent la migration du matériau de revêtement sur le support.

Pour la mise en oeuvre de ces techniques, l'énergie du plasma détermine la température de surface du support qui est un facteur important, car il faut que cette température soit suffisamment élevée pour permettre aux atomes et molécules de matériau de revêtement d'être mobiles et de s'intégrer correctement au support en vue d'obtenir une bonne cohésion entre support et revêtement et d'assurer une bonne homogénéité du revêtement.

Mais il faut également éviter qu'une élévation trop importante de la température du support ne provoque une dégradation du support lui-même.

Pour concilier ces deux contraintes antagonistes, il est nécessaire de réaliser le revêtement très lentement, de manière à permettre au support de diffuser vers l'extérieur une partie de la chaleur reçue. Or, une telle limitation de la vitesse de revêtement constitue un inconvénient important dans la perspective d'une exploitation industrielle.

En tout état de cause, le fait même d'exposer le support à des températures élevées rend cette technique assez lourde à gérer, car elle nécessite des moyens et des procédures de confinement particulier. De plus, ceci limite la gamme des matériaux à partir desquels le support peut être réalisé.

Il est également connu d'utiliser en combinaison avec les techniques citées ci-dessus, un faisceau laser qui favorise le dépôt des molécules de matériau de revêtement sur le support (le laser devant être de puissance élevée dans le cas d'une utilisation avec un plasma).

Mais ce perfectionnement ne répond que très imparfaitement aux inconvénients évoqués ci-dessus, car la vitesse de dépôt du matériau de revêtement demeure faible et la qualité du revêtement limitée.

A cet effet, différentes techniques ont été développées en vue d'améliorer la qualité du revêtement obtenu. On connaît en particulier :
- un premier type de technique mettant en oeuvre un rayonnement d'ions de moyenne énergie (de l'ordre de 20 à 30 KeV) en combinaison avec un plasma. Cette technique utilise l'énergie du rayonnement d'ions pour stimuler la condensation du matériau de revêtement sur le support, en respectant la structure cristallographique spécifique au matériau de revêtement et permet une répartition homogène du matériau de revêtement sur le support.
   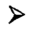 mais la vitesse de revêtement demeure faible dans le cas de ce premier type de technique.
- un deuxième type de technique utilisant des pulsations ultracourtes de bombardement du support par un rayonnement d'ions de haute densité d'énergie (supérieure à 300 KeV et associée à une fluence de l'ordre de 1J/cm²), qui produit un revêtement de qualité supérieure (revêtement très homogène pouvant être aussi lisse que du verre), par suite de la fusion de la couche superficielle se mélangeant au matériau de revêtement pendant chaque pulsation ultra brève, avant de se solidifier lors d'un refroidissement ultra rapide (phénomène dénommé « quenching » selon la terminologie anglo-saxonne, équivalent à un « trempage »).
   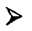 Il est cependant difficilement envisageable de mettre en oeuvre ce deuxième type de technique à l'échelle industrielle, car elle est lente comme les techniques évoquées ci-dessus (la proportion des ions énergétiques qui bombardent le support étant, à chaque pulsation, seulement de l'ordre de une pour un million de particules de la surface unitaire du solide irradié). De plus, le coût associé à la réalisation de pulsations de très haute énergie à des fréquences assez hautes pour envisager des revêtements d'épaisseur significative est prohibitif.

On précise qu'on connaît du document US 6 086 726 un procédé combinant à une étape de revêtement d'un support un bombardement par un faisceau ionique.

Le procédé divulgué par ce document comprend ainsi une étape unique de revêtement, après laquelle on bombarde le support revêtu par des ions de haute énergie.

On remarquera que dans ce procédé le bombardement ionique peut produire des effets à des profondeurs très variables dans l'épaisseur de la couche de revêtement et/ou du support.

Ce document indique en particulier que :
- dans certains modes de mise en oeuvre, ladite profondeur est de l'ordre du dixième seulement de l'épaisseur de la couche de revêtement, ce qui indique que seulement une partie de cette couche de revêtement est affectée par le bombardement,
- alors que dans d'autres modes de mise en oeuvre, ladite profondeur peut être supérieure à l'épaisseur de la couche de revêtement. On se référera en particulier à cet égard à la colonne 4, lignes 47 et suivantes de ce document.

Il apparaît ainsi que le procédé de ce document ne comprend pas de contrôle précis des conditions de bombardement ionique (et en particulier du niveau d'énergie des ions bombardés), en vue d'obtenir un effet précis précisément localisé (par exemple entre la couche de revêtement et le support revêtu).

On remarquera par ailleurs que ce procédé ne comprend qu'une unique étape de revêtement, et ne prévoit aucunement la succession de plusieurs étapes de revêtement.

On connaît également par le document WO 99/65 038 un procédé qui enseigne quant à lui la répétition d'une opération consistant à successivement ajouter de la poudre sur un support, puis à faire fondre au moins un composant de cette poudre par exposition à un faisceau ionique, pour créer un alliage.

On remarquera que ce procédé ne concerne aucunement une opération de revêtement, la poudre déposée n'étant pas assimilable à un revêtement cohérent de structure donnée tel que celui qui est, comme on va le voir, mis en oeuvre dans la présente invention.

En particulier, dans le procédé du document WO 99/65 038, le bombardement ionique a pour effet de conférer à la couche de poudre une cohérence structurelle dont elle est totalement dépourvue avant ce bombardement

On rappelle que l'invention s'inscrit dans le cadre de l'amélioration de revêtements cohérents.

Et le procédé du document WO 99/65 038 s'inscrit au contraire dans le cadre très particulier de l'utilisation d'une poudre (non cohérente), et de la création d'une structure cohérente par exposition à un faisceau ionique.

On connaît enfin par le document US 4 759 948 un procédé destiné à rendre uniforme une surface à revêtir, ledit procédé mettant en oeuvre à cet effet l'exposition de la surface du support à revêtir à un faisceau ionique.

Ce procédé n'enseigne ainsi qu'une étape préparatoire à un revêtement.

Et on remarquera que l'énergie du faisceau ionique n'est par conséquent pas adaptée pour provoquer une fusion de la surface.

Il apparaît ainsi que l'ensemble des procédés connus comporte des limitations, ou n'est pas adapté à l'objet de l'invention.

Un but de l'invention est de permettre de pallier à ces limitations.

Un but de l'invention est de permettre de réaliser un revêtement de très haute qualité, simple et rapide à mettre en oeuvre et dont le coût reste réduit.

Un autre but de l'invention est de réaliser un revêtement de très haute qualité sur des supports constitués de matériaux divers, pouvant avoir des températures de déformation, mouillage ou ramollissement très basses.

Afin d'atteindre ces buts, l'invention propose un procédé de revêtement d'un support selon la revendication 1.

Des aspects préférés, mais non limitatifs du procédé selon l'invention sont les suivants :
- Le procédé comprend la répétition d'enchaînements formés d'une phase de dépôt et d'une phase d'exposition à un bombardement d'ions.
- Chaque pulsation de bombardement d'ions a une durée inférieur à la microseconde, chaque pulsation de bombardements d'ions a une durée inférieure à cent nanosecondes,
- Le niveau d'énergie des ions bombardés est au moins de l'ordre de 300 à 500 KeV,
- La source de plasma mise en oeuvre dans les phases de dépôt de matériau est un plasmatron, ou une source de plasma à arc,
- Le matériau du support est un métal, un matériau composite ou un matériau plastique,
- Les ions d'énergie de haute densité correspondent à un support d'énergie sur le support de l'ordre de 0,01 à 5 Joules par centimètre carré, les ions de haute densité d'énergie correspondent à un apport d'énergie sur le support de l'ordre de 0,1 à 2 Joules par centimètre carré les ions de haute densité d'énergie correspondent à un apport d'énergie sur le support de l'ordre de 1 Joule par centimètre carré,
- L'épaisseur de revêtement a une épaisseur désirée,
- Ladite épaisseur est de l'ordre de 20 microns.

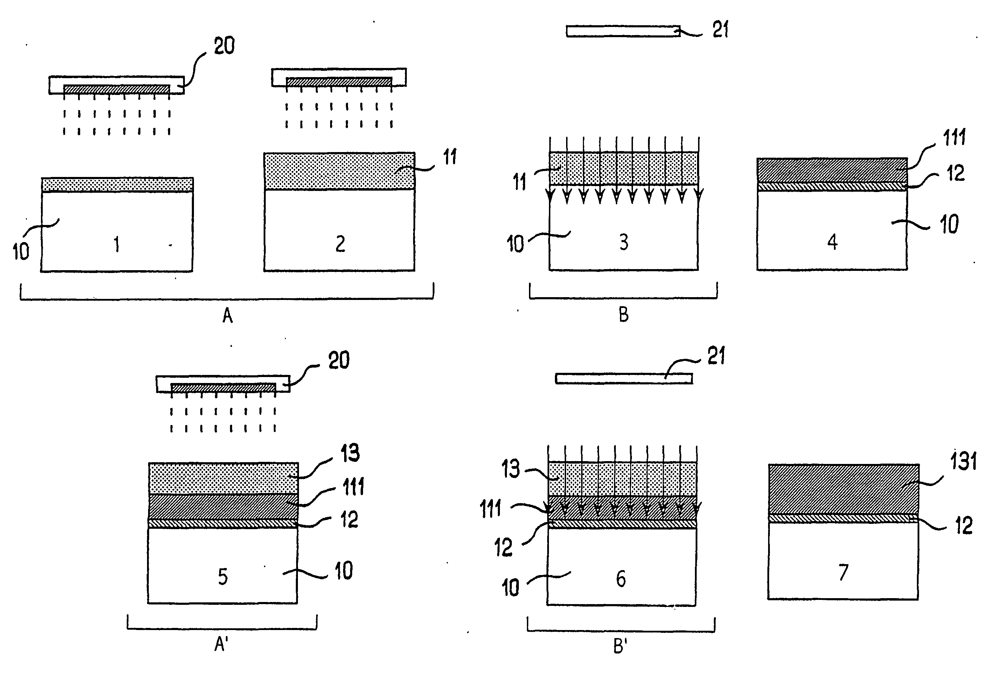

D'autres aspects, buts et avantages de l'invention apparaîtront mieux à la lecture de la description suivante d'une forme de réalisation du procédé selon l'invention, faisant référence la figure unique annexée qui représente schématiquement la succession des principales étapes du procédé selon l'invention.

En référence à cette figure unique, on expose tout d'abord lors d'une étape 1 un support 10 au rayonnement d'une source de plasma 20 de type plasmatron, ou une source de plasma à arc de fort courant (source à arc cathodique ou à arc à vide), ou toute autre source de plasma. La source 20 est elle-même située à l'intérieur d'un plasma.

En effet, la source de plasma 20 est située tout comme le support à l'intérieur d'une chambre qui contient un plasma ambiant. Généralement, ce plasma ambiant sera un plasma de faible énergie.

Une source d'énergie 21 est également représentée aux étapes B et B' de la figure.

On précise que la source 21 peut de manière générale être également toute source d'ions de haute densité d'énergie. On entend par « ions de haute densité d'énergie » des ions dont le flux dirigé vers un support préalablement revêtu d'une couche de revêtement possède une énergie suffisante pour pénétrer le support au-delà de la couche de revêtement déposée préalablement.

Plus précisément, les ions de haute densité d'énergie doivent pouvoir pénétrer à une profondeur de l'ordre de au moins 1,5 fois l'épaisseur de la couche de revêtement.

En outre, les ions de haute densité d'énergie doivent non seulement pénétrer de la sorte le support mais également être encore capables de transférer leur énergie au matériau du support de manière à amener le matériau dudit support, d'une température ambiante usuelle de l'ordre de 25 degrés centigrades, à la température de fusion dudit matériau du support.

On comprendra mieux l'intérêt de cette définition des ions de haute densité d'énergie à la lecture de la suite de la présente description.

On rappelle que les sources plasmatron sont des sources à arc thermique de grande puissance, qui utilisent la décharge d'un arc de produit par un courant important entre des électrodes concentriques dans une configuration qui peut être plane ou cylindrique, à l'intérieur d'un gaz précurseur, l'arc étant stabilisé par une rotation à haute vitesse d'éléments du dispositif.

Dans l'application concernée ici, on pourra utiliser un plasmatron plan dans lequel la cathode est un disque plat entouré d'une anode en forme d'anneau, et l'arc est formé à l'intérieur d'un gaz qui peut être inerte ou réactif, ledit arc étant stabilisé par un champ magnétique tournant.

Le support 10 peut être tout support que l'on désire revêtir (outil ou autre), et être constitué en une matière choisie parmi une très large gamme de métaux, d'oxydes ou de carbures ou de nitrures, ou même de matériaux composites (y compris des céramiques) ou des plastiques.

On verra en effet qu'un des avantages du procédé selon l'invention est qu'il peut être mis en oeuvre sur de très nombreux types de supports (même ceux ayant une température de fusion très basse), sans faire fondre ou dégrader ceux-ci par suite d'un échauffement trop important.

En effet, dans le cas de l'invention un avantage est que la température du support ne doit pas nécessairement être augmentée au-dessus d'une valeur de l'ordre de 40 degrés centigrades.

On précise en effet que selon l'invention il n'est pas besoin de chauffer préalablement le support avant l'étape de revêtement. Cependant, le support peut s'échauffer légèrement suite à l'exposition à un rayonnement d'ions de haute densité d'énergie, comme cela sera décrit plus en détails dans la suite de ce texte.

En tout état de cause, lors de cet échauffement, la température du support ne dépasse une valeur de l'ordre de 40 degrés centigrades.

Les particules peuvent être par exemple du TiN ou du CrN, mais le procédé s'applique également à tout type de particules de revêtement.

Lorsque l'épaisseur de la couche 11 a atteint une valeur prédéterminée (par exemple 0,5 microns) comme représenté à l'étape 2, on interrompt l'alimentation de la source 20 pour faire cesser le dépôt de particules sur ke support.

A ces fins, l'alimentation de la source 20 peut être commandée par un système utilisant un réseau neuronal permettant de commander en temps réel le fonctionnement de la source.

Les étapes 1 et 2 constituent ainsi une phase A de dépôt ininterrompu de matériau sur le support, permettant d'obtenir rapidement une couche d'épaisseur significative.

Mais en l'état, le dépôt obtenu de la sorte présenterait des qualités d'homogénéité, d'adhérence au support et d'état de surface qui seraient limitées (la couche présenterait une structure comportant des espaces de moindre densité et/ou des feuilles ou plaques).

Selon l'invention, on fait succéder à cette phase A de dépôt de matériau une phase B qui correspond à l'étape 3, lors de laquelle on expose le support 10 et la couche 11 qui le recouvre à une pulsation ultra brève (d'une durée qui est typiquement inférieure à la microseconde, et par exemple inférieure à 100 nanosecondes) d'un rayonnement d'ions légers dont l'énergie est au moins de l'ordre de 300 à 500 KeV, qui doit assurer sur le support une quantité de chaleur surfacique de l'ordre de 1 Joule par centimètre carré.

C'est ce flux d'ions légers qui correspond aux ions de haute densité d'énergie définis plus haut, et qui constitue un élément important de l'invention.

On précise que la valeur de 1 Joule par centimètre carré est une valeur moyenne indicative ; en tout état de cause la quantité de chaleur surfacique sur le support induite par l'exposition au rayonnement pulsé d'ions de haute densité d'énergie est généralement comprise entre 0,01 et 5 Joules par centimètre carré.

On observe toutefois que pour la plupart des matériaux cette valeur est comprise dans un intervalle allant de 0,1 à 2 Joules par centimètres carrés. Ces valeurs dépendent de la nature du matériau du support.

On précise également que la durée de la pulsation ultra brève (dont une durée indicative est comme indiqué ci-dessus de l'ordre de 100 nanosecondes), dépend également de la nature du support. La durée de cette pulsation doit être définie de manière à être assez brève pour empêcher une diffusion progressive et continue dans le support de la chaleur apportée par les ions de haute densité d'énergie.

En tout état de cause, la durée de la pulsation et le niveau de densité d'énergie des ions sont choisis de manière à ce que les ions traversent l'épaisseur de la couche de revêtement de matériau déposée lors de la phase de dépôt de matériau précédant la phase d'exposition à une pulsation de bombardement d'ions, pour dissiper l'énergie que ces ions conservent après leur traversée de la couche de revêtement dans une région immédiatement adjacente au fond de ladite couche de revêtement.

Le niveau d'énergie des ions mis en oeuvre dans cette deuxième phase est ainsi choisi de manière à ce que ces ions traversent la couche 11 pour atteindre la région du support qui est adjacente à cette couche, et délivrent l'énergie qui leur reste dans cette région du support (d'épaisseur de l'ordre du micron).

En pratique, le niveau d'énergie des ions est choisi de manière à ce que les ions traversent sensiblement toute épaisseur de la couche 11, ainsi qu'une région superficielle du support 10 adjacente à la couche 11 et d'une épaisseur qui peut être par exemple de l'ordre du micron, avant de dissiper l'énergie qui leur reste.

Plus précisément les ions délivrent une partie de leur énergie lors de la traversée de la couche 11, et modifient ainsi la structure de cette couche. La partie restante de l'énergie des ions est dissipée dans la région du support adjacente à la couche 11 pour provoquer la création d'un alliage entre cette région superficielle du support et le matériau de la couche 11.

La fluence associée à cette opération doit être suffisante pour porter la couche du matériau située dans la zone de portée des ions de la température du support à la température juste au-dessus du point de fusion dudit matériau de la couche 11. La phase B est ainsi une phase d'altération de structure.

Comme représenté à l'étape 4, on obtient ainsi à l'issue des phases A et B un revêtement du support 10 qui est constitué d'une couche supérieure 111 résultant de l'altération de la couche 11 par les ions bombardées pendant la phase B et d'une couche intermédiaire 12, plus fine d'alliage entre la couche 111 et le support 10.

La couche intermédiaire 12 d'alliage qui a été constituée par fusion du niveau inférieur de la couche 11 et de la région adjacente du support garantit ainsi une cohésion très forte entre le support et son revêtement.

Dès que l'impulsion ultra brève de bombardement d'ions est terminée, la couche intermédiaire 12 et la couche 111 se refroidissent extrêmement rapidement (à une vitesse de refroidissement de l'ordre de 10⁹ à 10¹⁰ degrés par seconde), du fait du gradient de température très important qui a été créé dans ces régions (la chaleur associée à l'énergie des ions n'ayant pas eu le temps de se diffuser à l'intérieur du support).

Ce refroidissement rapide de type « quenching » :
■ provoque la resolidification de la région 12 modifiée ce qui confère à l'ensemble (support + couches de revêtement) une cohésion très forte,
■ et favorise l'altération de la structure de la couche 111 et son durcissement, grâce à quoi cette couche 111 a une structure amorphe de granulométrie très fine avec une microstructure qui inclut des phases nanocristallines et métastables, et sa structure et son état de surface sont d'une qualité extrêmement haute, comparable à la qualité obtenue dans le préambule du présent texte.

La brièveté de l'impulsion pendant laquelle le support 10 et la couche de revêtement 11 sont soumis au rayonnement ionique (de l'ordre de la nanoseconde) permet à la fois :
■ de prévenir un échauffement du support, qui reste à une température de l'ordre de 40 degrés centigrades. Cette caractéristique est particulièrement avantageuse car elle permet de mettre en oeuvre le procédé selon l'invention sur une très grande variété de types de supports,
■ et de ne pas retarder le déroulement général du procédé, dont la vitesse d'exécution est déterminée par la durée de la phase A de dépôt de matériau.

Il apparaît ainsi que l'enchaînement des phases A et B permet de réaliser un revêtement de qualité extrêmement élevée en termes de densité, homogénéité, cohésion avec le support, état de surface, et d'épaisseur significative, le tout de manière simple (pas d'échauffement du support) et rapide.

De plus, ce procédé peut être mis en oeuvre sur une très grande variété de supports contrairement à la majorité des procédés existants.

Il est en outre possible d'obtenir une épaisseur de revêtement plus importante, en répétant autant de fois que nécessaire l'alternance d'une phase de dépôt de matériau A' lors de laquelle le support 10, la couche de transition 12 et la couche supérieure 111 de l'étape 4 sont à nouveau exposés à la source de plasma 20 activée dans son plasma, afin de constituer un nouveau dépôt 13 de la couche 111 (étape 5).

Lorsque l'épaisseur de la nouvelle couche 13 a atteint une épaisseur prédéterminée (par exemple ici encore de l'ordre de 0,5 microns), on expose à nouveau le support 10 et les couches qui le revêtent à une impulsion ultra brève de bombardement d'ions, dans une étape 6 qui constitue une phase B'.

Ici encore, l'énergie associée aux ions est choisie de telle sorte que ces ions bombardés pendant la phase B' traversent la couche 13, pour atteindre la région intermédiaire entre le revêtement 13 et son support 111 et provoquer une fusion et la création d'un alliage entre la couche 13 et le niveau supérieur de la couche 111 (on aura pris soin de choisir l'épaisseur de la couche 13 déposée lors de la phase A' suffisamment petite pour que les ions bombardés puissent traverser cette couche).

On obtient ainsi une altération et un durcissement de la couche 13, et son ancrage de très bonne qualité sur le revêtement déjà réalisé.

Et bien que le niveau d'énergie surfacique associé aux ions bombardés pendant les B et B' ne soit que de l'ordre de 1 à 2 Joules par centimètre carré, cette énergie est dissipée dans la région intermédiaire enter la dernière couche de revêtement et le dernier support, région qui a une épaisseur de 1 à 2 microns seulement, ce qui correspond à des taux de transfert d'énergie volumiques de l'ordre de 10⁴ Joules par centimètre cube, suffisants pour provoquer une fusion (contrairement à ce qui se passe dans les techniques connues « d'implantation d'ions »).

On obtient ainsi en 7 un support revêtu d'une couche de revêtement 131 de qualité extrêmement élevée, et il est possible de répéter les alternances de phases de dépôt de matériau et de phases de bombardement d'ions pour amener l'épaisseur de cette couche 131 à une valeur désirée.

Dans ce cas, chaque enchaînement d'une phase de dépôt de matériau et d'altération de structure permet d'augmenter l'épaisseur totale du revêtement, ainsi que de durcir et d'ancrer le nouveau dépôt sur le revêtement déjà réalisé.

Et ici encore, la durée des phases d'altération de structure et refroidissement est négligeable devant la durée des phases de dépôt de matériau, de sorte que les phases B et B' d'altération de structure ne diminuent pas la vitesse de déroulement du procédé selon l'invention qui est conditionnée par les phases de dépôt A et A'.

La Demanderesse a ainsi déterminé que la vitesse globale de revêtement pouvait être de l'ordre de 0,5 microns par minute, ce qui est tout à fait compatible avec une exploitation industrielle.

Par rapport aux techniques connues de revêtement assisté par bombardement avec des ions de moyenne énergie, le procédé selon l'invention est également beaucoup plus rapide, et offre en outre l'avantage associé à la création d'un alliage entre le revêtement et le support, ce qui augmente considérablement les qualités et la cohésion de l'ensemble.

On remarquera par ailleurs par rapport à des techniques du type de celles divulguées par le document US 6 086 726, le procédé selon l'invention permet d'obtenir des surfaces de revêtement très importantes, lesdites épaisseurs pouvant être de l'ordre de plusieurs microns (la Demanderesse ayant obtenu des épaisseurs de revêtement de l'ordre de 20 microns ou plus).

Cette répétition de phases alternatives de dépôt et de bombardement réalisées dans des conditions spécifiques permet en effet de réaliser des revêtements d'excellente qualité, et d'épaisseur désirée.

La phase de dépôt de matériau cohérent permet de déposer rapidement une quantité désirée de matériau de revêtement.

La phase d'altération de structure dudit dépôt, qui est réalisée avec un bombardement d'ions dont le niveau d'énergie est très précisément choisi, permet de mettre en oeuvre une pulsation de bombardement ionique très courte et très intense.

Et le choix de l'énergie de bombardement qui est fait de manière à ce que les ions pénètrent juste au-delà de la profondeur moyenne du nouveau revêtement offre une efficacité maximum, en particulier en ce qui concerne la solidarisation du nouveau revêtement avec la structure existante.

Par ailleurs, la densité d'énergie déposée par le faisceau ionique dans la couche de revêtement et dans le substrat est choisie de manière à être suffisante pour faire fondre la zone traversée par le faisceau ionique, mais également de manière à rester en dessous d'une valeur qui conduirait à la vaporisation de matériau dans cette zone.

L'énergie apportée à ladite zone provoque ainsi une fusion rapide du matériau local.

Et ce matériau fusionné, qui comprend le nouveau revêtement et la couche superficielle du substrat, est sujet à un phénomène de trempage rapide et se resolidifie dès la fin de la pulsation de bombardement.

Ce trempage mène à la formation de structures nanocristallines et d'alliages métastables, en offrant par ailleurs une cohérence extrêmement forte entre la couche de revêtement et le substrat.

La répétition de ces deux phases permet comme on l'a dit de réaliser un revêtement d'épaisseur désirée, couche après couche, sur un substrat de départ.

Suite à l'effet de fusion provoqué par le faisceau d'ions énergétique, chaque nouvelle couche de revêtement successif est fusionnée avec la surface se trouvant immédiatement en dessous.

Il en résulte que toutes les couches de revêtement successives sont fusionnées ensemble, formant une même et unique couche qui s'étend jusqu'au substrat de départ.

De plus, le procédé selon l'invention est simple à mettre en oeuvre (en particulier parce que la température du support de l'ordre de 40 degrés centigrades ne nécessite aucun moyen spécifique de protection ou de confinement) et donc facilement reproductible.

## Revendications

1. Procédé de revêtement d'un support (10) comprenant un premier matériau par une couche de revêtement comportant un deuxième matériau, comportant au moins une phase (A, A') de dépôt d'une couche d'épaisseur donnée de matériau cohérent (11, 13) sur la surface du support lors de laquelle on utilise une source (20) de plasma située dans un plasma ambiant, **caractérisé en ce que** chaque phase (A, A') de dépôt de matériau est suivie d'une phase (B, B') d'exposition du support et de la couche de matériau (11, 13) déposée à une pulsation de durée limitée d'un bombardement (21) d'ions de haute densité d'énergie de niveau de densité d'énergie choisi, la durée de pulsation et le niveau d'énergie des ions bombardés durant la phase (B, B') d'exposition à une pulsation de bombardement d'ions étant choisis de manière à ce que ces ions traversent l'épaisseur de la couche de matériau déposée lors de la phase (A, A') de dépôt de matériau précédant ladite phase (B, B') d'exposition à une pulsation de bombardement d'ions, pour dissiper l'énergie qui leur reste après cette traversée dans une région immédiatement adjacente au fond de ladite couche de matériau déposée.

2. Procédé selon la revendication précédente, **caractérisé en ce que** le procédé comprend la répétition d'enchaînements formés d'une phase de dépôt (A, A') et d'une phase (B, B') d'exposition à un bombardement d'ions.

3. Procédé selon l'une des revendications précédentes, **caractérisé en ce que** chaque pulsation de bombardement d'ions a une durée inférieure à la microseconde.

4. Procédé selon la revendication précédente, **caractérisé en ce que** chaque pulsation de bombardements d'ions a une durée inférieure à cent nanosecondes.

5. Procédé selon l'une des revendications précédentes, **caractérisé en ce que** le niveau d'énergie des ions bombardés est au moins de l'ordre de 300 à 500 KeV.

6. Procédé selon l'une des revendications précédentes, **caractérisé en ce que** la source de plasma (20) mise en oeuvre dans les phases de dépôt de matériau est un plasmatron, ou une source de plasma à arc.

7. Procédé selon l'une des revendications précédentes, **caractérisé en ce que** le matériau du support est un métal, un matériau composite ou un matériau plastique.

8. Procédé selon l'une des revendications précédentes, **caractérisé en ce que** les ions d'énergie de haute densité correspondent à un apport d'énergie sur le support de l'ordre de 0,01 à 5 Joules par centimètre carré.

9. Procédé selon l'une des revendications précédentes, **caractérisé en ce que** l'épaisseur de revêtement a une épaisseur désirée.

10. Procédé selon la revendication précédente, **caractérisé en ce que** ladite épaisseur est de l'ordre de 20 microns.

## Patentansprüche

1. Verfahren zum Beschichten eines Trägers (10), der ein erstes Material umfaßt, mit einer Beschichtungsschicht, die ein zweites Material umfaßt, das wenigstens eine Phase (A, A') zum Auftragen einer Schicht vorgegebener Dicke aus einem kohärenten Material (11, 13) auf der Oberfläche des Trägers umfaßt, bei der eine Plasmaquelle (20) verwendet wird, die sich in einem umgebenden Plasma befindet, **dadurch gekennzeichnet, daß** auf jede Phase (A, A') des Materialauftragens eine Phase (B, B') der Bestrahlung des Trägers und der aufgetragenen Materialschicht (11, 13) mit einer Pulsation begrenzter Dauer eines Beschusses (21) mit Ionen hoher Energiedichte mit einem ausgewählten Energiedichtewert folgt, wobei die Dauer der Pulsation und das Energieniveau der beschießenden Ionen während der Phase (B, B') der Bestrahlung mit einer Ionenbeschußpulsation so gewählt sind, daß diese Ionen die Dicke der während der Phase (A, A') der Materialauftragung, die der Phase (B, B') der Bestrahlung mit einer Ionenbeschußpulsation vorangeht, aufgetragenen Materialschicht durchqueren, um die Energie, die ihnen nach dieser Durchquerung verbleibt, in einem unmittelbar benachbarten Bereich am Boden der aufgetragenen Materialschicht zu verteilen.

2. Verfahren nach dem vorhergehenden Anspruch, **dadurch gekennzeichnet, daß** das Verfahren die Wiederholung der Aneinanderreihungen umfaßt, die aus einer Auftragungsphase (A, A') und einer Phase (B, B') der Bestrahlung durch einen Ionenbeschuß gebildet ist.

3. Verfahren nach einem der vorhergehenden Ansprüche, **dadurch gekennzeichnet, daß** jede Ionenbeschußpulsation weniger als eine Mikrosekunde dauert.

4. Verfahren nach dem vorhergehenden Anspruch, **dadurch gekennzeichnet, daß** jede Ionenbeschußpulsation weniger als hundert Nanosekunden dauert.

5. Verfahren nach einem der vorhergehenden Ansprüche, **dadurch gekennzeichnet, daß** das Energieniveau der beschießenden Ionen wenigstens in der Größenordnung von 300 bis 500 KeV liegt.

6. Verfahren nach einem der vorhergehenden Ansprüche, **dadurch gekennzeichnet, daß** die in den Materialauftragungsphasen eingesetzte Plasmaquelle (20) ein Plasmatron oder eine Plasmabogenquelle ist.

7. Verfahren nach einem der vorhergehenden Ansprüche, **dadurch gekennzeichnet, daß** das Material des Trägers ein Metall, ein Verbundwerkstoff oder ein Kunststoffmaterial ist.

8. Verfahren nach einem der vorhergehenden Ansprüche, **dadurch gekennzeichnet, daß** die Ionen hoher Energiedichte einem Energieeintrag auf dem Träger in der Größenordnung von 0,01 bis 5 Joule pro Quadratzentimeter entsprechen.

9. Verfahren nach einem der vorhergehenden Ansprüche, **dadurch gekennzeichnet, daß** die Dicke der Beschichtung eine gewünschte Dicke hat.

10. Verfahren nach dem vorhergehenden Anspruch, **dadurch gekennzeichnet, daß** die Dicke in der Größenordnung von 20 Mikrometer liegt.

## Claims

1. Method for coating a support (10) comprising a first material with a coating layer comprising a second material, including at least one step (A, A') for depositing a layer of given thickness of coherent material (11, 13) on the surface of the support during which a source (20) of plasma located in an ambient plasma is used, **characterised in that** each material deposition step (A, A') is followed by a step (B, B') of exposure of the support and of the deposited layer of material (11, 13) to a pulse of high energy density ion bombardment (21) for a limited duration at a chosen energy density level, the duration of the pulse and the energy level of bombarded ions during the step (B, B') of exposure to an ion bombardment pulse being chosen such that these ions cross the thickness of the layer of material deposited during the step (A, A') of material deposition preceding said step (B, B') of exposure to an ion bombardment pulse, to dissipate their remaining energy after this crossing, into a region immediately adjacent to the base of said layer of deposited material.

2. Method according to the above claim, **characterised in that** the method includes the repetition of sequences formed of a deposition step (A, A') and a step (B, B') of exposure to ion bombardment.

3. Method according to any one of the preceding claims, **characterised in that** each ion bombardment pulse has a duration of less than a microsecond.

4. Method according to the preceding claim, **characterised in that** each ion bombardment pulse has a duration of less than a hundred nanoseconds.

5. Method according to any one of the preceding claims, **characterised in that** the energy level of the bombarded ions is at least of the order of 300 to 500 keV.

6. Method according to any one of the preceding claims, **characterised in that** the plasma source (20) used in the material deposition step is a plasmatron, or a plasma arc source.

7. Method according to any one of the preceding claims, **characterised in that** the support material is a metal, a composite material or a plastic material.

8. Method according to any one of the preceding claims, **characterised in that** the high energy density ions correspond to an energy input on the support of the order of 0.01 to 5 Joules per square centimetre.

9. Method according to any one- of the preceding claims, **characterised in that** the coating thickness has a desired thickness.

10. Method according to the preceding claim, **characterised in that** said thickness is of the order of 20 microns.
